# EUROPÄISCHE PATENTSCHRIFT

(11) **EP 0 588 355 B1**
(45) Veröffentlichungstag und Bekanntmachung des Hinweises auf die Patenterteilung: **26.11.1997**
(21) Anmeldenummer: 93114978.5
(22) Anmeldetag: 17.09.1993
(51) Int. Cl.: C30B 15/26, G01B 11/22

(54) **Verfahren zur Regelung der Schmelzenhöhe während des Ziehens von Einkristallen**
Process for control of the melt level during single crystal pulling
Procédé pour le réglage du niveau du bain fondu pendant le tirage de monocristaux

(30) Priorität: 17.09.1992 DE 4231162
(43) Veröffentlichungstag der Anmeldung: 23.03.1994
(73) Patentinhaber: Wacker Siltronic Gesellschaft für Halbleitermaterialien Aktiengesellschaft, 84489 Burghausen (DE)
(72) Erfinder: Bauer, Werner, D-84489 Burghausen (DE); Hofstetter, Christian, D-84489 Burghausen (DE); Mittelbach, Bernd, D-84489 Burghausen (DE); Berger, Walter, D-84359 Simbach am Inn (DE)
(74) Vertreter: Rimböck, Karl-Heinz, Dr.

(56) Entgegenhaltungen:
- EP-A- 0 183 221
- EP-A- 0 472 907
- US-A- 4 350 557
- PATENT ABSTRACTS OF JAPAN, unexamined applications, C Field, Band 13, Nr. 273, 22. Juni 1989 THE PATENT OFFICE JAPANESE GOVERNMENT Seite 157 C 609
- PATENT ABSTRACTS OF JAPAN, unexamined applications, C Field, Band 9, Nr. 171, 16. Juli 1985 THE PATENT OFFICE JAPANESE GOVERNMENT Seite 66 C 291

## Beschreibung

Die Erfindung betrifft ein Verfahren zur Regelung der Schmelzenhöhe während des Ziehens eines Einkristalls aus einer Schmelze nach dem Czochralski-Verfahren.

Bei der Kristailzucht nach dem Czochralski-Verfahren wächst ein stabförmiger Einkristall aus einem Impfling heran. Der einkristalline Impfling wird mit einer in einem Tiegel befindlichen Schmelze in Kontakt gebracht und langsam axial von der Schmelzenoberfläche weggezogen. An der Grenzfläche zwischen dem Einkristall und der Schmelze kristallisiert dabei laufend schmelzflüssiges Material aus und vergrößert das Volumen des Einkristalls. Der Ziehvorgang wird in der Regel abgebrochen, wenn der Vorrat an schmelzflüssigem Material aufgebraucht oder eine vorgegebene Kristallgröße erreicht ist. Der Erfolg der Kristallzucht hängt insbesondere von der Kontrolle der Temperatur und der Stoffströme in der Schmelze und im Gasraum über der Schmelze ab. Da die Schmelzenhöhe, also das Niveau der Schmelzenoberfläche bezogen auf ein existierendes oder ein gedachtes Referenzniveau, einen entscheidenden Einfluß darauf hat, verdient ihre Regelung besondere Aufmerksamkeit. Die genaue Kenntnis der Schmelzenhöhe ist gemäß der Patentschrift US 4,915,775 auch deshalb notwendig, um den Kristalldurchmesser möglichst genau einstellen zu können. Es ist deshalb erwünscht, möglichst während des gesamten Ziehvorganges die Schmelzenhöhe zu kontrollieren und gegebenenfalls zu verändern. Normalerweise wird die Schmelzenhöhe, die mit dem Verbrauch an flüssigem Material sinken würde, durch ein axiales Anheben des Tiegels konstant gehalten, damit die relative Lage der seitlich vom Tiegel angebrachten Heizelemente zur Schmelzenoberfläche erhalten bleibt. Mit dem Nachchargieren von festem oder geschmolzenem Material in den Tiegel ist die Schmelzenhöhe ebenfalls beeinflußbar. Diese Verfahrensvariante hat den Vorteil, daß mehrere Kristalle nahezu kontinuierlich gezogen werden können. Die Schmelzenhöhe wird in der genannten Patentschrift dadurch ermittelt, daß die Zeit gemessen wird, die benötigt wird, den Impfkristall von einer Referenzposition bis zum Kontakt mit der Schmelzenoberfläche abzusenken. Ein Nachteil dieser Methode ist, daß die Schmelzenhöhe nur einmal vor dem Ziehen des Kristalls und nicht kontinuierlich gemessen werden kann. Aus den Patent Abstracts of Japan, Vol. 13, Nr. 273, 22.6.1989, S. 157 C 609 geht unter Bezugnahme auf die Patentanmeldung JP-A-1-69591 hervor, ein Reflexionsbild auf der Schmelzenoberfläche aufzunehmen, aus der Größe des Bildes die Höhe der Schmelze zu berechnen und durch Heben oder Senken des Schmelztiegels die gemessene Schmelzenhöhe an eine Soll-Schmelzenhöhe anzugleichen. Es wird vorgeschlagen, das Bild eines den wachsenden Einkristall zylinderförmig umgebenden Heizelementes aufzunehmen. In der Patentschrift US 4,454,096 wird zur Messung der Schmelzenhöhe ein Lichtstrahl auf die Schmelzenoberfläche gerichtet und das von der Oberfläche reflektierte Licht von einem Sensor registriert. Die Methode, mit der in der genannten Patentschrift die Schmelzenhöhe von geschmolzenem Material in einem Vorratstiegel bestimmt wird, ist jedoch nur schwierig in einem Ziehtiegel durchzuführen, weil der Einkristall den Strahlengang behindert. Die Situation wird noch problematischer, wenn ein Ziehverfahren, wie es beispielsweise in der Patentschrift US 4,330,362 beschrieben ist, praktiziert wird: Liegt über dem Tiegel, aus dem heraus der Kristall gezogen wird, partiell oder nahezu vollständig eine Abdeckung, ist eine Anordnung von auf die Schmelzenoberfläche einstrahlender Lichtquelle und das reflektierte Licht registrierendem Sensor nahezu unmöglich.

Die Aufgabe der vorliegenden Erfindung bestand deshalb darin, ein Verfahren zur Regelung der Schmelzenhöhe in einem Tiegel während des Ziehens eines Einkristalls aus einer Schmelze nach dem Czochralski-Verfahren aufzuzeigen, wonach die Schmelzenhöhe mit einfachen Mittelnkontinuierlich und mit einer hohen Genauigkeit ermittelt und geregelt werden kann.

Die Aufgabe wird durch ein Verfahren gemäß dem kennzeichnenden Teil des Anspruchs 1 gelöst.

Das Verfahren nutzt die Entdeckung, daß Gegenstände so über dem Tiegel angebracht werden können, daß sie auf der Schmelzenoberfläche eine Reflexion verursachen. Zwischen der Geometrie der Reflexion und der Geometrie des Gegenstandes besteht gemäß den Regeln der geometrischen Optik ein linearer Zusammenhang. Es ist daher möglich, aus der Beobachtung der Reflexion den Abstand des Gegenstandes zur Schmelzenoberfläche und damit die Schmelzenhöhe zu ermitteln und während des Ziehens des Kristalls zu regeln. Da die Lage des Gegenstandes auch als Bezugsgröße für die Schmelzenhöhe verwendet werden kann, wird der Gegenstand nachfolgend als mechanische Referenzmarke bezeichnet. Der Übergang: Reflexion --> reflexionsfreie Schmelzenoberfläche ist von einer ausgeprägten Helligkeitsänderung begleitet, so daß sich die Reflexion deutlich von der umgebenden Schmelzenoberfläche abzeichnet. Dieser Übergang ist immer Bestandteil des für die Schmelzenhöhen-Regelung ausgewählten Untersuchungsbereiches. Selbstverständlich muß nicht die gesamte, von der mechanischen Referenzmarke verursachte Reflexion für die Schmelzenhöhen-Regelung ausgewertet werden. Es genügt, wenn mindestens ein Teil der Reflexion zum Untersuchungsbereich gehört.

Es ist vorteilhaft, die mechanische Referenzmarke in ihrer Form so zu gestalten, daß sie zumindest ein charakteristisches, auch an der Reflexion rasch erkennbares, geometrisches Merkmal aufweist. Als Erkennungsmerkmale eignen sich besonders einfache geometrische Figuren, wie Dreiecke, Vierecke oder Kreise. Es ist unerheblich, ob das Merkmal beispielsweise als runde Scheibe oder als rundes Loch in einem beliebig geformten Körper verwirklicht ist: in beiden Fällen ist die erzeugte Reflexion für die Ermittelung des Abstandes der mechanischen Referenzmarke zur Schmelzenoberfläche tauglich. Die Reflexionen unterscheiden sich nur dadurch, daß im ersten Fall eine Helligkeitsänderung im Übergang: scheibenförmige Reflexion --> reflexionsfreie Schmelzenoberfläche und im anderen Fall eine Helligkeitsänderung im Übergang: scheibenförmige, reflexionsfreie Schmelzenoberfläche ---> Reflexion beobachtet wird.

Die mechanische Referenzmarke muß aus einem Material gefertigt werden, das gegenüber den beim Kristallziehen vorherrschenden Temperaturen beständig ist. Vorzugsweise werden Materialien verwendet, deren Wärmeausdehnung gering ist, so daß deswegen bei der Regelung der Schmelzenhöhe nur ein kleiner Korrekturfaktor zu berücksichtigen ist. Da das erfindungsgemäße Verfahren mit besonderem Vorteil zum Ziehen von Einkristallen aus Silicium für Halbleiterzwecke geeignet ist, ist es darüber hinaus angebracht, Materialien zu verwenden, die keine oder nur tolerierbare Mengen an Fremdstoffen abgeben, damit der Kristall nicht verunreinigt und sein einkristallines Wachstum nicht behindert wird. Besonders geeignet sind Keramik-Werkstoffe, Metalle oder Metalllegierungen, die Molybdän oder Wolfram enthalten.

Gemäß der Erfindung wird ein Teil der üblichen Tiegelabdeckungen, wie sie beispielsweise in der bereits zitierten Patentschrift US 4,330,362 beschrieben sind, als mechanische Referenzmarke verwendet. Solche Abdeckungen besitzen in der Regel eine kreisförmige Öffnung, die den wachsenden Einkristall konzentrisch umschließt. Die Reflexion auf der Schmelzenoberfläche weist infolgedessen ebenfalls eine kreisförmige Kontur auf. In einer bevorzugten Ausgestaltung wird die Abdeckung mit einem zusätzlichen Erkennungsmerkmal versehen, beispielsweise dadurch, daß die Öffnung an einer bestimmten Stelle definiert und charakteristisch erweitert ist.

Sind die geometrischen Daten der mechanischen Referenzmarke, beispielsweise der Durchmesser der Öffnung der Abdeckung oder die Geometrie des zusätzlichen Erkennungsmerkmals, bekannt, so sind der Abstand der mechanischen Referenzmarke zur Schmelzenoberfläche und die Schmelzenhöhe bezogen auf die Lage der mechanischen Referenzmarke nach den Regeln der geometrischen Optik mit Hilfe eines aufgenommenen Bilds der beobachteten Reflexion absolut berechenbar. Selbstverständlich geht der Blickwinkel, mit der die Beobachtung der Reflexion erfolgt, in die Rechnung ein. Eine Absolutrechnung kann auch dann erfolgen, wenn Ähnlichkeitsbeziehungen einer mechanischen Referenzmarke oder Teilen davon zu einer Standard-Referenzmarke, deren geometrische Daten bekannt sind, ausgenutzt werden.

Der Abstand der mechanischen Referenzmarke zur Schmelzenoberfläche muß nicht notwendigerweise absolut bestimmt werden. Es genügt häufig, eine Eichung vorzunehmen und die in einem bestimmten Untersuchungsbereich aufgenommene Reflexion mit einem Satz geeichter Bilder der Reflexion zu vergleichen. Bei der Eichung werden Bilder der Reflexion in einem bestimmten Untersuchungsbereich in Abhängigkeit verschiedener Abstände der mechanischen Referenzmarke zur Schmelzenoberfläche aufgenommen. Einem der Abstände wird ein bestimmter Wert zugewiesen, auf den sich alle anderen Abstände beziehen. Jedes aufgenommene Bild erhält auf diese Weise einen bestimmten Abstandswert zugeordnet. Stimmt beim Vergleich ein aufgenommenes Bild mit einem geeichten Bild überein, so ist der gesuchte Abstand der mechanischen Referenzmarke zur Schmelzenoberfläche gleich dem, der dem geeichten Bild zugeordnet ist.

Die Schmelzenoberfläche und die Reflexion darauf wird mit einer optischen Aufnahmeeinrichtung, beispielsweise mit einer CCD-Kamera oder mit einem lichtempfindlichen Diodenarray, aufgenommen. Die Helligkeit der Aufnahme wird pixelweise erfaßt und elektronisch ausgewertet. Es ist natürlich zweckmäßig, die von der optischen Aufnahmeeinrichtung gelieferten Bilddaten nicht nur für die erfindungsgemäße Schmelzenhöhen-Regelung, sondern auch für die im Stand der Technik beschriebene Kristalldurchmesser-Bestimmung zu verwenden. Die Auswertung des aufgenommenen Bilds für die Schmelzenhöhen-Regelung beinhaltet zunächst, daß ein Pixel des Untersuchungsbereichs als zur Reflexion gehörend betrachtet wird, wenn die Helligkeit in diesem Pixel innerhalb vorbestimmter Grenzwerte liegt. Entsprechendes gilt für Pixel, die zur reflexionsfreien Schmelzenoberfläche gehörend gezählt werden sollen. Aus dem so aufbereiteten Bild wird anschließend die Reflexion eines ausgewählten Untersuchungsbereichs herangezogen, um nach den Regeln der geometrischen Optik den Abstand, den die mechanische Referenzmarke zur Schmelzenoberfläche hat, auf elektronischem Wege zu errechnen. Ist eine absolute Berechnung des Abstands nicht möglich, wird der Abstand durch einen Vergleich des Bilds mit einem Satz geeichter Bilder ermittelt. Schließlich wird von der Bildverarbeitungseinrichtung ein dem gefundenen Abstand proportionales, aktuelles Ist-Signal ausgegeben.

Mit Hilfe dieses Ist-Signals ist man in der Lage, den Abstand der mechanischen Referenzmarke zur Schmelzenoberfläche und damit die Schmelzenhöhe zu regeln. Das Ist-Signal dient als Eingangsgröße für eine Regeleinrichtung. Diese vergleicht es mit einem Soll-Signal, das proportional zu einem gewünschten Abstand der mechanischen Referenzmarke zur Schmelzenoberfläche ist. Das Soll-Signal wird vorzugsweise von einem Rechner als Sollwert-Geber an die Regeleinrichtung ausgegeben. Letztere vergleicht das Ist-Signal mit dem Soll-Signal und erzeugt nach Maßgabe des festgestellten Unterschieds ein Stell-Signal, mit dessen Hilfe die Schmelzenhöhe geändert werden kann. Durch die Wahl des Soll-Signals kann die Schmelzenhöhe während des Ziehens des Kristalls konstant gehalten oder nach einem bestimmten Programm variiert werden.

Prinzipiell könnte aber auch auf elektronische Hilfsmittel zur Regelung der Schmelzenhöhe zumindest teilweise verzichtet werden: um beispielsweise den Abstand der mechanischen Referenzmarke zur Schmelzenoberfläche konstant halten zu können, genügt es unter Umständen schon, den von der Kamera aufgenommenen Untersuchungsbereich der Reflexion genau auf Veränderungen hin zu beobachten. Treten Veränderungen auf, so muß die Schmelzenhöhe solange geändert werden, bis sich das ursprüngliche Bild der Reflexion wieder einstellt. In der Regel ist jedoch eine automatisierte Regelung der Schmelzenhöhe dieser Vorgehensweise vorzuziehen.

Da es sehr einfach ist, die Schmelzenhöhe über den Tiegelhub zu beeinflussen, wird vorzugsweise ein Stell-Signal erzeugt, das den Tiegel in Abhängigkeit der Abweichung von Soll- und Ist-Signal solange hebt oder senkt, bis die Abweichung aufgehoben ist. Eine andere Möglichkeit besteht darin, die Schmelzenhöhe über ein Stellsignal zu ändern, das die Zufuhr von festem oder schmelzflüssigem Material in den Schmelztiegel beeinflußt. Allerdings läßt sich auf diese Weise die Schmelzenhöhe nicht absenken.

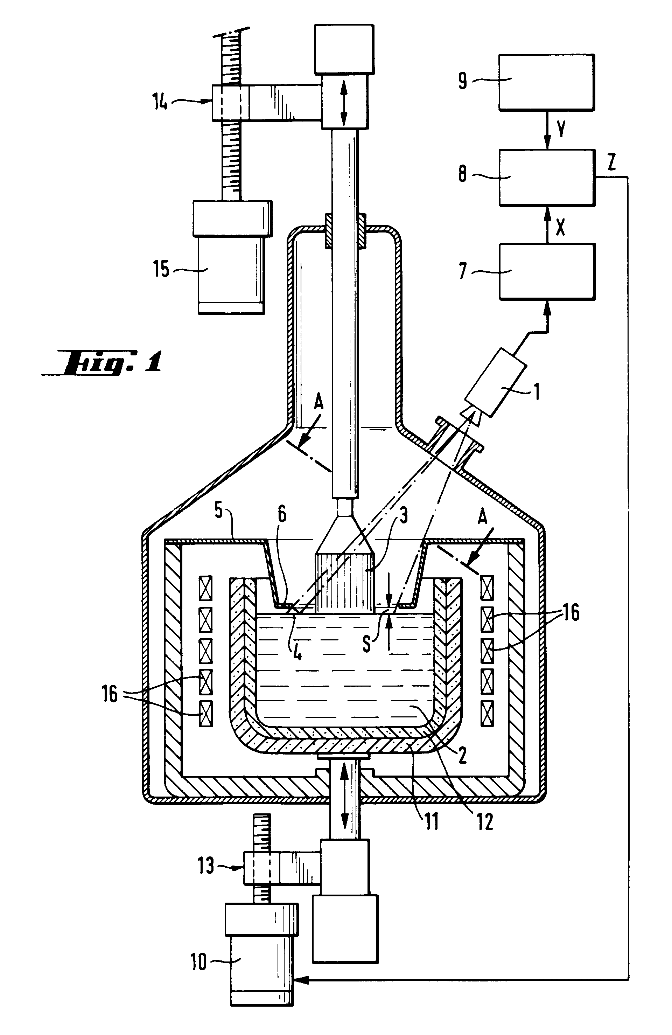

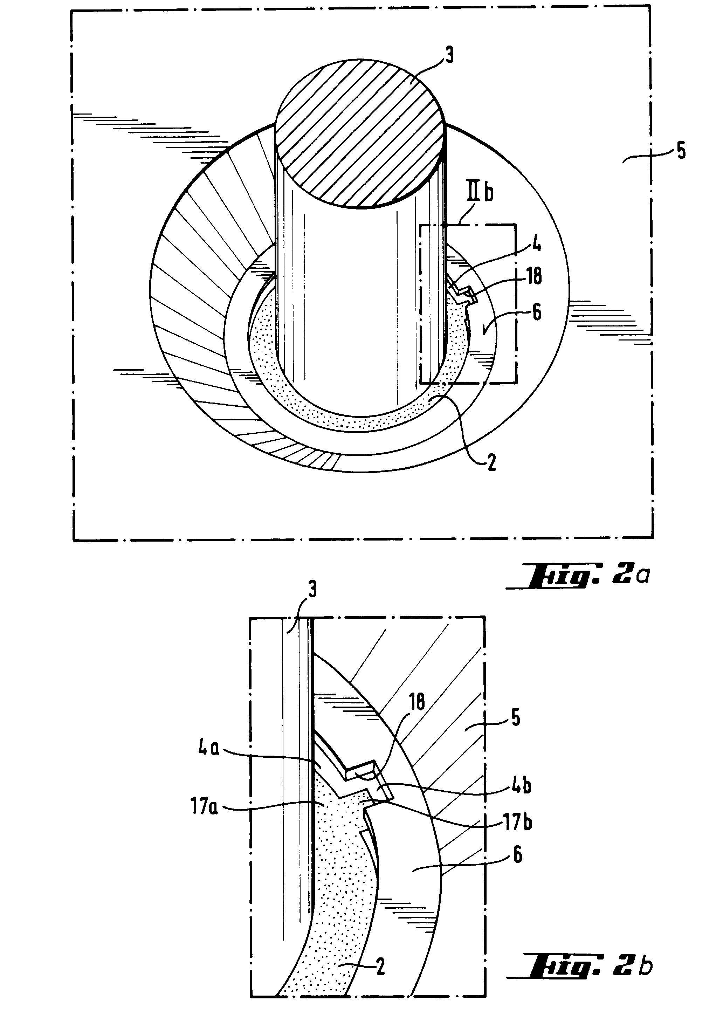

Das Verfahren wird nachstehend an Hand der Figuren 1, 2a und 2b erläutert.

In den Figuren sind gleiche Merkmale mit gleichen Bezugsziffern versehen.

Es zeigen:
Figur 1 eine Vorrichtung zum Ziehen von Einkristallen nach dem Czochralski-Verfahren.
Figur 2a den Querschnitt der Vorrichtung entlang der Schnittlinie A-A schräg von oben betrachtet.
Figur 2b einen rechteckigen, vergrößerten Ausschnitt aus Figur 2a.

Wie in Figur 1 gezeigt, ist die optische Aufnahmeeinrichtung 1 so auf die Oberfläche der Schmelze 2 gerichtet, daß sowohl der Bereich der Phasengrenze zwischen dem Einkristall 3 und der Schmelze, als auch der Bereich der Schmelzenoberfläche, auf dem sich die Reflexion 4 befindet, beobachtet werden kann. Die mechanische Referenzmarke ist in dieser bevorzugten Ausführungsform als topfförmige Abdeckung 5 gestaltet. Zwischen dem Rand 6 der Abdeckung 5, die den wachsenden Einkristall koaxial umschließt, und dem Rand des Einkristalls ist ein einige Millimeter breiter Spalt, durch den die Reflexion 4 beobachtbar ist. Sie wird vom parallel zur Schmelzenoberfläche liegenden Rand 6 der Abdeckung 5 verursacht. Der gewählte Untersuchungsbereich wird von der optischen Aufnahmeeinrichtung 1, beispielsweise einer CCD-Kamera, aufgenommen und in einer nachgeschalteten Bildverarbeitungs-Einrichtung 7 elektronisch aufbereitet. Dazu gehört zunächst, daß jedes einzelne Pixel, das zum gewählten Untersuchungsbereich gehört, an Hand der gemessenen Helligkeitswerte danach unterschieden wird, ob es die Reflexion oder die reflexionsfreie Schmelzenoberfläche repräsentiert. Aus dieser Information wird dann unter Berücksichtigung der gespeicherten geometrischen Daten der mechanischen Referenzmarke (in diesem Fall genügt für eine Absolutrechnung der Durchmesser des Randes der Abdeckung) oder eines gespeicherten Satzes von geeichten Bildern des Untersuchungsbereichs der Abstand S des Randes der Abdeckung zur Schmelzenoberfläche ermittelt. Die Bildverarbeitungs-Einrichtung gibt ein dem aktuellen Ist-Abstand proportionales Ist-Signal X aus. Das Ist-Signal wird anschließend in einer Regeleinrichtung 8 mit einem vorbestimmten, zum Soll-Abstand proportionalen, Soll-Signal Y verglichen. Das Soll-Signal ist beispielsweise in einem als Sollwert-Geber 9 dienenden Rechner gespeichert und wird bei Bedarf an die Regeleinrichtung ausgegeben. Wird eine Abweichung festgestellt, erzeugt die Regeleinrichtung ein Stell-Signal Z für den Antriebsmotor 10, der den Tiegel, bestehend aus einem äußeren Graphitrezipienten 11 und einem inneren Quarztiegel 12, mit Hilfe des Hub-und Senk-Mechanismus 13 in seiner vertikalen Position verändert, bis Ist- und Soll-Signal übereinstimmen. Vorzugsweise wird die Schmelzenhöhe auf einen gleichbleibenden Wert geregelt, damit sich der Abstand S der Abdeckung zur Schmelzenoberfläche nicht verändert. Der Einkristall kann dann über den Ziehmechanismus 14, der vom Motor 15 bewegt wird, aus der Schmelze gezogen werden, wobei gewährleistet ist, daß sich die Lage der seitlich des Tiegels angebrachten Heizelemente 16 bezüglich der Schmelzenhöhe nicht verändert, obwohl die Menge an geschmolzenem Material mit dem Kristallwachstum ständig abnimmt.

In Figur 2a ist schematisch der Querschnitt der Vorrichtung entlang der Schnittlinie A-A aus einer Blickrichtung von schräg oben gezeigt. Von der Schmelzenoberfläche 2 ist durch die Abdeckung 5 ein Teil nicht einsehbar. Der Rand 6 der Abdeckung umschließt den wachsenden Einkristall 3 und verursacht auf der Schmelzenoberfläche eine Reflexion 4, die sich in ihren Helligkeitswerten von den reflexionsfreien Bereichen der Schmelzenoberfläche unterscheiden läßt. In Figur 2b ist ein rechteckiger Ausschnitt aus Figur 2a vergrößert dargestellt. Als Untersuchungsbereich zur Regelung der Schmelzenhöhe nach dem erfindungsgemäßen Verfahren eignet sich jeder Bereich, der zumindest einen Teil der vom Rand 6 der Abdeckung 5 verursachten Reflexion 4a und die ihn umgebende reflexionsfreie Schmelzenoberfläche 17a beinhaltet. Bevorzugt wird jedoch ein Untersuchungsbereich gewählt, bei dem sich eine markante Reflexion 4b dadurch ergibt, daß am Rand der Abdeckung ein rechteckiger Einschnitt 18 vorgenommen worden ist. Ist dieses charakteristische Formmerkmal in der Abdeckung vorhanden, so ist es auch beim Betrachten der Reflexion 4b und der reflexionsfreien Schmelzenoberfläche 17b zu finden.

Das beschriebene Verfahren erlaubt eine präzise und einfache Regelung der Schmelzenhöhe. Es ist gleichermaßen für die kontinuierliche wie für die absatzweise Zucht von Einkristallen verwendbar und unterliegt keiner Beschränkung, wenn die Schmelze aus besonderen Gründen teilweise abgedeckt ist.

## Patentansprüche

1. Verfahren zur Regelung der Schmelzenhöhe von schmelzflüssigem Material in einem Tiegel während des Ziehens eines Einkristalls nach dem Czochralski-Verfahren, gekennzeichnet dadurch, daß
a) ein Teil einer topfförmigen Tiegelabdeckung mit einem charakteristischen Formmerknal als mechanische Referenzmarke in einem definierten Abstand S parallel zur Schmelzenoberfläche angebracht ist und auf der Schmelzenoberfläche eine Reflexion verursacht;
b) ein Bild von einem, die Reflexion mindestens teilweise beinhaltenden Untersuchungsbereich auf der Schmelzenoberfläche aufgenommen wird;
c) mit Hilfe des aufgenommenen Bilds der Abstand S der mechanischen Referenzmarke zur Schmelzenoberfläche ermittelt und ein diesem Abstand proportionales Ist-Signal erzeugt wird.
d) das Ist-Signal mit einem vorgegebenen Soll-Signal verglichen wird und bei einem festgestellten Unterschied ein Stell-Signal zur Änderung der Schmelzenhöhe erzeugt wird.

2. Verfahren nach Anspruch 1, dadurch gekennzeichnet, daß ein Stell-Signal erzeugt wird, mit dem die Schmelzenhöhe über Heben oder Senken des Tiegels geändert wird.

3. Verfahren nach Anspruch 1, dadurch gekennzeichnet, daß ein Stell-Signal erzeugt wird, mit dem die Schmelzenhöhe über die Zufuhr von aufzuschmelzendem oder bereits schmelzflüssigem Material geändert wird.

4. Verfahren nach einem oder mehreren der Ansprüche 1 bis 3, dadurch gekennzeichnet, daß
der Abstand zwischen der mechanischen Referenzmarke und der Schmelzenoberfläche auf einen vorgegebenen Wert geregelt wird.

## Claims

1. Process for controlling the melt level of molten material in a crucible while pulling a single crystal according to the Czochralski process, characterized in that
a) a part of a pot-shaped crucible cover with a characteristic shape feature as a mechanical reference mark is arranged at a defined distance S parallel to the melt surface and causes a reflection on the melt surface;
b) an image of an evaluation area, which contains the reflection at least in part, on the melt surface is recorded;
c) with the aid of the recorded image the distance S of the mechanical reference mark from the melt surface is determined and an actual signal proportional to this distance is generated;
d) the actual signal is compared with a predefined setpoint signal and, if a difference is observed, a control signal is generated to change the melt level.

2. Process according to Claim 1, characterized in that a control signal is generated by means of which the melt level is changed via raising or lowering of the crucible.

3. Process according to Claim 1, characterized in that a control signal is generated by means of which the melt level is changed via the infeed of material to be melted or already molten.

4. Process according to one or more of Claims 1 to 3, characterized in that the distance between the mechanical reference mark and the melt surface is controlled to a predefined value.

## Revendications

1. Procédé de régulation du niveau de matière en fusion dans un creuset pendant le tirage d'un monocristal suivant la méthode de Czochralski, caractérisé en ce que
a) une partie d'un couvercle de creuset en forme de pot présentant une forme caractéristique est disposée en tant que marque de référence mécanique à une distance définie S parallèlement à la surface de la matière en fusion et provoque une réflexion sur la surface de la matière en fusion;
b) une image d'une zone d'exploration contenant au moins partiellement la réflexion sur la surface de la matière en fusion est enregistrée;
c) la distance S séparant la marque de référence mécanique de la surface de la matière en fusion est déterminée à l'aide de l'image enregistrée et un signal réel proportionnel à cette distance est généré;
d) le signal réel est comparé à un signal de consigne prédéterminé et, si une différence est constatée, un signal de réglage est généré pour modifier le niveau de matière en fusion.

2. Procédé suivant la revendication 1, caractérisé en ce qu'un signal de réglage est généré, grâce auquel le niveau de matière en fusion est modifié par élévation ou abaissement du creuset.

3. Procédé suivant la revendication 1, caractérisé en ce qu'un signal de réglage est généré, grâce auquel le niveau de matière en fusion est modifié par l'apport de matière à fondre ou déjà en fusion.

4. Procédé suivant une ou plusieurs des revendications 1 à 3, caractérisé en ce que la distance séparant la marque de référence mécanique de la surface de la matière en fusion est réglée à une valeur prédéterminée.
